# EUROPÄISCHE PATENTSCHRIFT

(11) **EP 1 198 344 B1**
(45) Veröffentlichungstag und Bekanntmachung des Hinweises auf die Patenterteilung: **25.06.2003**
(21) Anmeldenummer: 00943638.7
(22) Anmeldetag: 23.05.2000
(51) Int. Cl.: B32B 3/26, B32B 15/01, B81B 1/00, F28D 9/00, B01J 19/00

(54) **VERFAHREN ZUM HERSTELLEN VON MIKROBAUTEILEN**
METHOD FOR PRODUCING MICROCOMPONENTS
PROCEDE DE PRODUCTION DE MICROELEMENTS

(30) Priorität: 28.05.1999 DE 19926025
(43) Veröffentlichungstag der Anmeldung: 24.04.2002
(73) Patentinhaber: ATOTECH Deutschland GmbH, 10553 Berlin (DE)
(72) Erfinder: THIES, Andreas, D-14167 Berlin (DE); CRÄMER, Konrad, D-14167 Berlin (DE); MEYER, Heinrich, D-14109 Berlin (DE)
(74) Vertreter: Effert, Bressel und Kollegen
(86) Internationale Anmeldenummer: DE0001676
(87) Internationale Veröffentlichungsnummer: WO00073056

(56) Entgegenhaltungen:
- DE-A- 19 708 472
- US-A- 5 192 623
- US-A- 5 534 328
- US-A- 5 798 042

## Beschreibung

Die Erfindung betrifft ein Verfahren zum Herstellen von Mikrobauteilen mit mindestens einer Einzellage, die in der chemischen Industrie unter anderem für Synthesereaktionen und auf anderen Gebieten, beispielsweise als Reaktoren für die Wasserstofferzeugung zur Energieumwandlung (Brennstoffzellen), eingesetzt werden können, sowie von Wärmeaustauschern, Mischern und Verdampfern.

In der Literatur wird seit einigen Jahren über chemische Mikroreaktoren berichtet, die gegenüber den herkömmlichen Produktionsanlagen zur Herstellung chemischer Verbindungen Vorteile aufweisen. Hierbei handelt es sich um eine Anordnung von Reaktionszellen, deren Abmessungen von wenigen Mikrometern bis zu einigen Millimetern betragen und somit sehr viel kleiner sind als die herkömmlicher Reaktoren. Diese Reaktionszellen sind so gestaltet, daß in ihnen physikalische, chemische oder elektrochemische Reaktionen ablaufen können. Im Gegensatz zu einem herkömmlichen porösen System (heterogene Katalyse) sind die Abmessungen dieser Zellen durch die Konstruktion definiert, also planmäßig mit einem technischen Verfahren herstellbar. Auch die Anordnung einzelner Reaktionszellen im Ensemble des Reaktors ist geordnet, insbesondere periodisch in einer, zwei oder drei Dimensionen. Zu den chemischen Mikroreaktoren werden im erweiterten Sinne auch die notwendigen Zuund Ableitungsstrukturen für die Fluide (Flüssigkeiten, Gase) und Sensoren und Aktoren gerechnet, beispielsweise Ventile, die den Stoffstrom durch die einzelnen Zellen kontrollieren, sowie Heizelemente.

Die Verwendung von chemischen Mikroreaktoren zur Wasserstofferzeugung für Brennstoffzellen zur Energieumwandlung ist beispielsweise von R.Peters et al. in "Scouting Study about the Use of Microreactors for Gas Supply in a PEM-Fuel Cell System for Traction", Proc. of the 1^{st} Int. Conf. on Microreaction Technology, Frankfurt, 1997 beschrieben worden.

Dieses Konzept für chemische Mikroreaktoren wurde auch auf Wärmeaustauscher angewendet. In diesem Fall sind in dem Wärmeaustauscher mindestens zwei voneinander getrennte Fluidkanäle vorhanden, die zur Übertragung von Wärme von Fluid in dem einen Kanal zu Fluid in dem anderen Kanal dienen.

Zur Herstellung chemischer Mikroreaktoren bzw. von Wärmeaustauschern gibt es eine Reihe von Vorschlägen:

Beispielsweise wird das LIGA-Verfahren (Lithographie, Galvano-Formung, Abformung) eingesetzt. Hierbei wird eine Kunststoffschicht, meistens Polymethylmethacrylat (PMMA), mittels Synchrotronstrahlung belichtet und anschließend entwickelt. Die derart erzeugte Struktur wird mit einem elektrolytischen Verfahren mit Metall ausgefüllt. Die Metallstruktur kann dann in weiteren Verfahrensschritten mittels einer Kunststoffabformung (Kunststoffspritzverfahren) vervielfältigt werden. Dieses Verfahren ist von W.Ehrfeld und H.Lehr in Radiat. Phys. Chem., Band 45, Seiten 349 bis 365 beschrieben worden.

Auch die Methoden, die in der Halbleiterindustrie zur Strukturierung von Siliziumoberflächen entwickelt worden sind, wurden ebenfalls zur Herstellung von Mikroreaktoren übernommen. Beispielsweise wurde von J.J.Lerou et al. in "Microfabricated Minichemical Systems: Technical Feasibility", DECHEMA Monographs, Volume 132, Seiten 51 bis 69 ein Verfahren beschrieben, bei dem drei geätzte Silizium-Wafer und zwei End-Wafer an den Außenseiten miteinander verbunden wurden. Ferner wurde ein mit polykristallinen Silberpartikeln gefüllter Wärmeaustauscher, der ebenfalls als Mikroreaktor ausgebildet war, verwendet.

In gleicher Weise geht das Herstellverfahren für Mikroreaktoren, das in US-A-5,534,328 beschrieben ist, von geätzten Silizium-Wafern aus, die zu einem Stapel verbunden werden. Es werden aber auch andere Materialien für die Mikroreaktoren genannt, beispielsweise Metalle, Polymere, Keramiken, Glas und Composite-Materialien. Zur Durchführung katalytischer Reaktionen wird u.a. vorgeschlagen, die Wände der Reaktionskanäle in den Reaktoren mit einer katalytischen Schicht zu überziehen.

In EP 0 212 878 A1 ist ein Verfahren zur Herstellung eines Wärmeaustauschers beschrieben, bei dem die Strömungskanäle des Wärmemediums in Stahlplatten durch chemisches Ätzen gebildet werden. Die Stahlplatten werden anschließend durch Diffusionsbonden miteinander verschweißt.

In WO-A-9215408 ist ein Verfahren zur Herstellung von Mikrosieben beschrieben, bei dem in einen mit einer ätzfesten Schicht überzogenen flächigen Träger Löcher mit einem bestimmten Muster durch Plasmatechnik geätzt werden. Mehrere dieser gelochten Träger werden anschließend miteinander verbunden.

In DE 197 08 472 A1 ist ein Herstellverfahren für chemische Mikroreaktoren beschrieben, bei dem Fluidkanäle in einzelnen Ebenen gebildet werden, indem mit Metalloberflächen versehene Substrate mittels photolithographischer Techniken oder Siebdruckverfahren strukturiert und die erhaltenen Kanalstrukturen durch Metallabtrags- oder -auftragsverfahren gebildet werden. Die einzeln hergestellten Ebenen werden anschließend zu einem Stapel zusammengefaßt und fest miteinander verbunden. Beispielsweise können die Kanäle durch partielles Wegätzen der Metallschicht auf dem Substrat erzeugt werden.

Die bisher bekannten Methoden zur Herstellung der chemischen Mikroreaktoren und Wärmeaustauscher weisen vielfältige Nachteile auf. Beispielsweise sind komplizierte und/oder teuere Techniken zur Herstellung der Kanäle erforderlich. In einigen Fällen ist die Herstellung der Reaktoren ausschließlich auf Silizium als Material beschränkt.

Häufig ist es auch nötig, eine funktionale Beschichtung auf den Kanalwänden zum Einstellen vorgegebener Eigenschaften der Mikrobauteile herzustellen. So kann beispielsweise ein Mikroreaktor aus einem aus Kupfer hergestellten Wärmeaustauscher gefertigt werden, indem die Kanäle mit einer stromlos abgeschiedenen Metallschicht überzogen werden, beispielsweise mit Palladium. In der chemischen Reaktionstechnik dienen die funktionellen Oberflächenschichten beispielsweise zur Katalyse chemischer Reaktionen. Eine nachträgliche Beschichtung der Strömungskanäle in den Ebenen mit einem galvanotechnischen Verfahren ist häufig jedoch nicht möglich, da die funktionellen Schichten in diesem Falle wegen der elektrischen Abschirmung durch den Reaktor oder Wärmeaustauscher selbst nicht auf elektrolytischem Wege aufgebracht werden können. Auch bei der stromlosen Metallisierung hat sich herausgestellt, daß eine sichere Beschichtung nicht möglich ist, da die üblicherweise verwendeten Metallisierungsbäder auf unterschiedliche Strömungsgeschwindigkeit der Metallisierungsflüssigkeit an den zu beschichtenden Oberflächen sehr empfindlich reagieren. Unter diesen Bedingungen werden unter anderem solche Oberflächenbereiche stromlos metallisiert, an denen die Metallisierflüssigkeit langsam vorbeiströmt, während Oberflächenbereiche, an denen die Flüssigkeit mit hoher Geschwindigkeit vorbeiströmt, nicht mit Metall überzogen werden. Bei sehr engen Kanälen können Probleme bei der stromlosen Metallabscheidung auftreten, die auf der sehr hohen Badbelastung (zu beschichtende Oberfläche pro Badvolumen) beruht, so daß sich nur ungenügende Schichtqualitäten einstellen. Möglicherweise wird eine flächendeckende Schichtbildung gänzlich unmöglich. Außerdem können mittels stromloser Verfahren nur bestimmte Metalle abgeschieden werden.

Gasabscheideverfahren zum Auftragen von Schichten sind in diesem Falle praktisch kaum anwendbar.

In den Fällen, in denen die funktionalen Schichten vor dem Zusammenfügen der Einzellagen zum Mikrobauteil aufgebracht werden, hat sich auch das Verbinden der einzelnen Bauteillagen als problematisch herausgestellt, da keine sichere Verbindung zwischen den einzelnen Lagen hergestellt werden konnte. Häufig wiesen die aus den Einzellagen hergestellten Bauteile Undichtigkeiten auf, aus denen das unter relativ hohem Druck stehende Fluid aus den Kanälen nach außen drang.

Ferner sind die funktionalen Schichten gegenüber den üblicherweise zum Zusammenfügen der Einzellagen angewendeten Fügetemperaturen nicht beständig. Die funktionalen Schichten werden insbesondere in den Fällen, in denen das Material eine niedrigere Schmelz- oder Umwandlungstemperatur aufweist als die Temperatur beim Zusammenfügen, geschädigt oder sogar zerstört. Es können insbesondere auch Edelmetalle, wie Platin, Iridium, Palladium und Gold, zur Bildung der funktionalen Schichten aufgetragen werden. Diese Metalle haben zwar einen höheren Schmelzpunkt als das üblicherweise für das Mikrobauteil verwendete Kupfer als Grundmaterial und sollten daher bei einem Fügeverfahren, bei dem die Grundmaterialien zweier Einzellagen miteinander verschweißt werden, thermisch beständig sein. Allerdings wurde in diesen und anderen ähnlich gelagerten Fällen auch festgestellt, daß beispielsweise beim Diffusionsbonden derart beschichteter mikrostrukturierter Reaktorfolien so hohe Bondtemperaturen erforderlich sind, daß sich die funktionale Schicht und das Grundmaterial miteinander vermischen, noch bevor es zu einer ausreichenden Verbindung der Grundmaterialien untereinander kommt. Damit wird die Funktionalität der Schicht zerstört, beispielsweise einer Palladiumschicht auf einer aus Kupfer bestehenden Einzellage, da Palladium unter diesen Bedingungen in das Kupfer schnell eindiffundiert.

Aus diesen Gründen wurden Herstellverfahren, bei denen die funktionalen Schichten vor dem Zusammenfügen der Einzellagen aufgebracht werden, als nicht praktikabel angesehen.

Der vorliegenden Erfindung liegt von daher das Problem zugrunde, Mikrobauteile mit mindestens einer Einzellage herzustellen, die von Wänden begrenzte innere Strukturen, beispielsweise Strömungskanäle, in den Bauteilen und funktionale Schichten auf den Wänden der Strukturen aufweisen. Die Mikrobauteile sollen für eine Vielzahl von unterschiedlichen Anwendungen in der chemischen Reaktionstechnik, zum Wärmeaustausch, zum Mischen von Stoffen oder zum Verdampfen von Flüssigkeiten geeignet sein. Insbesondere soll es möglich sein, für verschiedene Anwendungen des Mikrobauteils unterschiedliche Beschichtungen auf die Kanaloberflächen aufzubringen. Ferner soll das Herstellverfahren möglichst preiswert und schnell durchführbar sein, ohne daß hohe Ausfallraten beim Fertigen der Mikrobauteile entstehen. Derartige Mikroreaktoren, Wärmeaustauscher, Mischer und Verdampfer sollen auch in großen Stückzahlen einfach und kostengünstig herstellbar sein. Insbesondere soll es möglich sein, Mikrobauteile herzustellen, die keine Probleme hinsichtlich der Dichtigkeit der Strömungskanäle aufweisen, und bei dem keine Probleme hinsichtlich der Stabilität der funktionalen Schichten beim Fügen der Einzellagen auftreten.

Gelöst wird dieses Problem durch das Verfahren nach Anspruch 1. Bevorzugte Ausführungsformen der Erfindung sind in den Unteransprüchen angegeben.

Insbesondere das Problem, daß es mit den bekannten Herstellverfahren nicht gelingt, Mikroreaktoren und andere Mikrobauteile herzustellen, die völlig frei von Undichtigkeiten an den Fügestellen sind, kann durch das erfindungsgemäße Verfahren gelöst werden. Erst durch umfangreiche Untersuchungen konnte die Ursache der Undichtigkeiten damit erklärt werden, daß die funktionalen Schichten häufig einen störenden Einfluß auf den Zusammenhalt der Lagen untereinander ausüben. Als Lösung dieses Problems ergibt sich, daß die funktionalen Schichten vor dem Stapeln und Zusammenfügen der Einzellagen miteinander und mit einem die Strömungskanäle abschließenden Segment ausschließlich auf den Wänden der Kanäle gebildet werden. Dadurch wird nämlich vermieden, daß funktionale Schichten auch an den Stellen auf den mikrostrukturierten Lagen gebildet werden, die für das Zusammenfügen der Lagen erforderlich sind.

Das erfindungsgemäße Verfahren bietet außerdem den Vorteil, daß das Fügeverfahren bei geringer Temperatur durchgeführt werden kann. Dadurch können auch Mikrobauteile mit temperaturempfindlichen funktionalen Schichten hergestellt werden, ohne daß diese Schichten beeinträchtigt werden. Da unter diesen Bedingungen eine Diffusion der funktionalen Schichten in das Grundmaterial der ersten Metallschicht oder Metallfolie weitgehend unterbunden werden kann, können auch thermisch empfindliche funktionale Schichten eingesetzt werden.

Durch das Verfahren stellen sich auch die Probleme nicht ein, die dann auftreten, wenn die funktionalen Schichten erst nach dem Zusammenfügen der Einzellagen zum Mikrobauteil aufgebracht werden. Insbesondere können problemlos auch Gasabscheideverfahren zum Auftragen von Schichten eingesetzt werden, um beispielsweise mit einem stromlosen Metallabscheideverfahren nicht herstellbare Schichten zu bilden. Femer gelingt auch eine stromlose oder elektrolytische Metallisierung ohne weiteres.

Das erfindungsgemäße zum Herstellen der Mikrobauteile dienende Verfahren besteht aus folgender Abfolge von Verfahrensschritten:
A. Herstellen einer Einzellage durch
   a. Herstellen einer ersten Metallschicht oder einer Metallfolie;
   b. Bilden der inneren Strukturen in und/oder auf der ersten Metallschicht oder Metallfolie, beispielsweise der Strömungskanäle, durch geeignete Ätzverfahren und/oder Metallauftragsverfahren;
   c. Bilden der funktionalen Schichten ausschließlich auf den Wänden der inneren Strukturen;
B. danach Stapeln und Zusammenfügen der Einzellage mit einem die Strömungskanäle abschließenden Segment oder mehrerer Einzellagen miteinander und mit dem abschließenden Segment.

Die Strömungskanäle in und/oder auf der ersten Metallschicht oder Metallfolie werden in einer Ausführungsform der Erfindung vorzugsweise durch folgende Verfahrensschritte gebildet:
b. Abbilden der Strömungskanäle auf der ersten Metallschicht oder Metallfolie durch ein Strukturierungsverfahren; und
b'. selektives Ätzen der beim Strukturieren freigelegten Bereiche der ersten Metallschicht oder Metallfolie.

Als Abbildungsverfahren können folgende Verfahrensalternativen eingesetzt werden:
b1. Überziehen mindestens einer Oberfläche der ersten Metallschicht oder Metallfolie mit einer photoempfindlichen Schicht, beispielsweise einem in der Leiterplattentechnik oder Halbleitertechnik üblicherweise eingesetzten Photoresist, Belichten der photoempfindlichen Schicht mit dem Muster der Strömungskanäle und Freilegen der ersten Metallschicht oder Metallfolie an allen Stellen, die den zu bildenden Kanälen entsprechen;
b2. Überziehen mindestens einer Oberfläche der ersten Metallschicht oder Metallfolie mit einer Siebdrucklackschicht an den Stellen auf der Oberfläche, die den zu bildenden Kanälen nicht entsprechen;
b3. Laminieren einer perforierten Folie, beispielsweise einer Kunststofffolie, auf mindestens eine Oberfläche der ersten Metallschicht oder Metallfolie, wobei die Perforationen an allen Stellen der Oberfläche vorgesehen sind, die den zu bildenden Kanälen entsprechen.

Grundsätzlich kann auch ein Metallresist eingesetzt werden, d.h. eine zweite Metallschicht, die auf die erste Metallschicht oder die Metallfolie aufgebracht wird, und die mit einem der vorstehend beschriebenen Verfahren strukturiert wird. Hierzu wird eine der vorstehend genannten Abdeckschichten bzw. die perforierte Folie auf die Metallresistschicht aufgebracht, selbst strukturiert und in der Metallresistschicht Perforationen an den Stellen eingebracht, an denen die Metallresistschicht freigelegt ist. Anschließend wird die Abdeckschicht oder die perforierte Folie vor der Weiterverarbeitung wieder entfernt.

Die photoempfindliche Schicht, die Siebdrucklackschicht oder die perforierte Folie kann zwischen den Verfahrensschritten c (Bilden der funktionalen Schichten ausschließlich auf den Wänden der Strömungskanäle) und B (Stapeln und Zusammenfügen der Einzellagen und des Abschlußsegments) oder nach Verfahrensschritt B wieder entfernt werden.

In einer weiteren Ausführungsform der Erfindung können auch weitere Metallschichten vor dem Zusammenfügen der Einzellagen ausschließlich auf die nicht mit den funktionalen Schichten überzogenen Oberflächenbereiche der ersten Metallschicht oder Metallfolie aufgebracht werden, indem folgende Verfahrensschritte durchgeführt werden:
d. Abdecken ausschließlich der funktionalen Schichten durch einen Schutzfilm, der in einem anderen Lösungsmittel löslich ist als die photoempfindliche Schicht, die Siebdrucklackschicht oder die perforierte Folie;
e. Bilden weiterer Metallschichten nach dem Entfernen der photoempfindlichen Schicht, der Siebdrucklackschicht oder der perforierten Folie auf den freiliegenden Oberflächenbereichen der ersten Metallschicht oder Metallfolie; und
f. Entfernen des Schutzfilmes.

Mit dieser Verfahrensvariante können beispielsweise Metallschichten auf die Oberflächenbereiche der ersten Metallschicht oder Metallfolie aufgebracht werden, die als Lotschichten beim Zusammenfügen der Einzellagen dienen. Beispielsweise könnte eine Zinn/Blei- oder Zinn/Wismut-Legierungsschicht abgeschieden werden.

In einer weiteren Variante zu der letztgenannten Verfahrensweise kann anstelle der weiteren Metallschicht auch eine Kleberschicht ausschließlich auf die nicht mit den funktionalen Schichten überzogenen Oberflächenbereiche der ersten Metallschicht oder Metallfolie aufgetragen werden, indem
d. ausschließlich die funktionalen Schichten durch einen Schutzfilm abgedeckt werden;
e. die Kleberschichten nach dem Entfernen der photoempfindlichen Schicht, der Siebdrucklackschicht oder der perforierten Folie auf den freiliegenden Oberflächenbereichen der ersten Metallschicht oder Metallfolie gebildet werden; und
f. der Schutzfilm wieder entfernt wird.

Kleberschichten dienen ebenso wie die zuvor genannten Lotschichten zum Zusammenfügen der Einzellagen, wobei die Kleberschichten insbesondere dann eingesetzt werden, wenn besonders temperaturempfindliche funktionale Schichten in den Strömungskanälen gebildet werden, so daß eine erhöhte Temperatur beim Zusammenfügen nicht eingestellt werden darf.

In einer weiteren vorteilhaften Ausführungsform der Erfindung werden die mit funktionalen Schichten versehenen Strömungskanäle in der ersten Metallschicht oder Metallfolie durch folgende Abfolge von Verfahrensschritten gebildet:
c. Bilden einer funktionalen Schicht auf der ersten Metallschicht oder Metallfolie;
b. Abbilden der Strömungskanäle durch eine der folgenden Verfahrensalternativen:
b1. Überziehen mindestens einer Oberfläche der funktionalen Schicht mit einer photoempfindlichen Schicht, Belichten der photoempfindlichen Schicht mit dem Muster der Strömungskanäle und Freilegen der mit der funktionalen Schicht überzogenen ersten Metallschicht oder Metallfolie an allen Stellen, die den zu bildenden Kanälen entsprechen; oder
b2. Überziehen mindestens einer Oberfläche der funktionalen Schicht mit einer Siebdrucklackschicht an den Stellen auf der Oberfläche, die den zu bildenden Kanälen nicht entsprechen; oder
b3. Laminieren einer perforierten Folie auf mindestens eine Oberfläche der funktionalen Schicht, wobei die Perforationen an allen Stellen der Oberfläche vorgesehen sind, die den zu bildenden Kanälen entsprechen; und
b'. Bilden von Vertiefungen in der funktionalen Schicht und gegebenenfalls in der ersten Metallschicht oder Metallfolie durch selektives Ätzen der freiliegenden Bereiche der funktionalen Schicht und gegebenenfalls der ersten Metallschicht oder Metallfolie;
b" Bilden von Metallstegen ausschließlich in den in Verfahrensschritt b' gebildeten Vertiefungen.

Für den Fall, daß die photoempfindliche Schicht, die Siebdrucklackschicht oder die perforierte Folie über die in den Vertiefungen gebildeten Metallstege hinausragt, kann durch Schleifen und/oder Polieren eine durch die Metallstege und die photoempfindliche Schicht, die Siebdrucklackschicht oder die perforierte Folie gebildete im wesentlichen ebene Oberfläche hergestellt werden. Auch in diesem Fall wird die photoempfindliche Schicht, die Siebdrucklackschicht oder die perforierte Folie vor dem Zusammenfügen der Einzellagen wieder entfernt. Die Stege bilden die Wände der Strömungskanäle.

Nachdem die Einzellagen nach einer der vorstehend beschriebenen Verfahrensalternativen hergestellt sind, wird das Mikrobauteil durch Stapeln und Zusammenfügen der Einzellagen miteinander und mit dem Abschlußsegment hergestellt. Hierzu kann je nach angewendeter Technik ein Löt- oder Schweißverfahren, beispielsweise ein Diffusionsbondverfahren, oder ein Klebeverfahren eingesetzt werden.

Vorzugsweise besteht die erste Metallschicht oder Metallfolie aus Kupfer, Stahl oder Aluminium.

Zur weiteren Erläuterung des Verfahrens wird auf die Figuren 1 bis 4 verwiesen.
Es zeigen:
- **Figur 1:**: eine schematische Darstellung des Verfahrensablaufes in einer ersten Verfahrensvariante A;
- **Figur 2:**: eine schematische Darstellung des Verfahrensablaufes in einer zweiten Verfahrensvariante B;
- **Figur 3:**: eine schematische Darstellung des Verfahrensablaufes in einer dritten Verfahrensvariante C;
- **Figur 4:**: eine schematische Darstellung des Verfahrensablaufes in einer vierten Verfahrensvariante D.

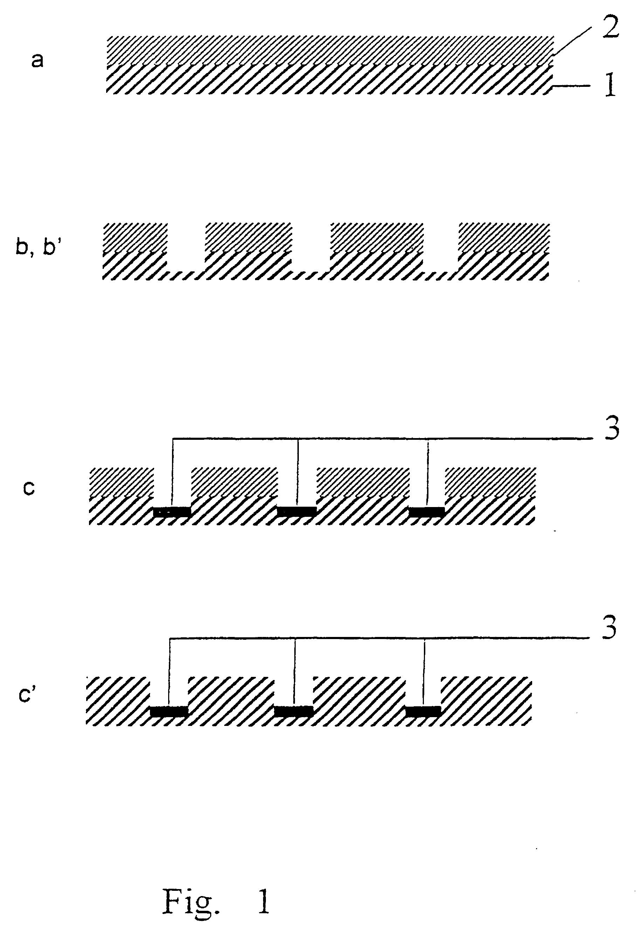

In **Figur 1** ist der Verfahrensablauf für die Herstellung einer Einzellage in der Verfahrensgrundform (Variante A) dargestellt. Gemäß Verfahrensschritt **a** wird zunächst eine Metallfolie **1** hergestellt, beispielsweise aus Kupfer. Grundsätzlich kann die Folie auch aus einem änderen Metall bestehen, beispielsweise aus Stahl oder Aluminium.

Die Kupferfolie **1** kann beispielsweise durch ein elektrolytisches Kupferabscheideverfahren hergestellt werden. Derartige Verfahren werden bei der Herstellung von Kupferfolien zum Einsatz in der Leiterplattentechnik eingesetzt und sind von daher bekannt. Die Metallfotie kann eine Dicke von 1 bis 500 µm aufweisen. Üblicherweise haben diese Folien eine Dicke von etwa 18 µm.

Anstelle einer Metallfolie **1** zum Herstellen der Einzellage kann auch eine erste Metallschicht auf einem Träger eingesetzt werden.

Auf die Metallfolie **1** wird anschließend eine photoempfindliche Schicht **2**, beispielsweise ein negativ arbeitender Photolack (oder eine Siebdrucklackschicht oder eine perforierte Folie) ganzflächig aufgebracht. Grundsätzlich kann auch eine Metallresistschicht aus einem Metall abgeschieden werden, das beim nachfolgenden Ätzen der Metallfolie nicht angegriffen wird. Zur Strukturierung der Metallresistschicht wird eines der Strukturierungsverfahren unter Verwendung von photoempfindlichen oder Siebdrucklackschichten oder einer perforierten Folie eingesetzt.

Anschließend wird der Photolack **2** gemäß Verfahrensschritt **b** dann an den Stellen mit dem Muster der zu bildenden Strömungskanäle belichtet, an denen die Strömungskanäle in der Metallfolie **1** nicht gebildet werden sollen. Beim nachfolgenden Entwicklungsschritt werden daraufhin alle nichtbelichteten Bereiche der Photolackschicht (oder Siebdrucklackschicht oder perforierten Folie) entfernt, in denen die Strömungskanäle gebildet werden sollen.

Danach wird die Metallfolie **1** in Verfahrensschritt **b'** an den freigelegten Stellen mit einem geeigneten Ätzmedium, beispielsweise einer CuCl₂- oder einer FeCl₃-Lösung, geätzt, so daß sich in diesen Bereichen Vertiefungen bilden, die den zu bildenden Strömungskanälen entsprechen.

Anschließend wird die gewünschte funktionale Schicht **3** gemäß Verfahrensschritt **c** auf den Wänden und dem Boden der gebildeten Vertiefungen in der Metallfolie **1** abgeschieden. Die Art des Abscheideverfahrens richtet sich nach der Art des Materials der funktionalen Schicht. Beispielsweise können Edelmetallschichten ohne weiteres mit einem elektrolytischen Metallabscheideverfahren gebildet werden. Alternativ können auch ein stromloses Metallisierungsverfahren oder Metallabscheideverfahren aus der Gasphase, beispielsweise ein PVD-, CVD-, PECVD-, Sputter- oder Aufdampf-Verfahren, eingesetzt werden. Alternativ kann auch ein Sol-Gel-Verfahren zur Bildung von Silikatoder anderen Oxidschichten angewendet werden, oder es können auch Molekülschichten, die spezifische katalytische Eigenschaften aufweisen, chemisorbiert oder adsorbiert oder auch Kunststoffschichten oder Keramikschichten gebildet werden. Die Keramikschichten sind insbesondere dann vorteilhaft, wenn eine große Oberfläche an den Strömungskanalwänden erzeugt werden soll. Für diesen Zweck werden poröse Keramikschichten gebildet, beispielsweise Oxidschichten durch Aufsputtern. Besonders gut geeignet ist auch eine aufgedampfte Aluminiumschicht, die nachträglich durch Eloxieren oder Behandeln beispielsweise mit Salpetersäure zu einer Aluminiumoxidschicht umgewandelt werden kann. Eine derartige Schicht kann als Träger für Katalysatoren dienen, mit denen diese Schicht imprägnierbar ist. Die funktionale Schicht kann ihrerseits auch aus verschiedenen Schichten aufgebaut sein. Diese Schichten können u.a. als trägerfixierte Katalysatoren dienen. Als funktionale Schichten im erfindungsgemäßen Sinne sind auch aufgerauhte Strömungskanalwände anzusehen, die beispielsweise durch Aufrauhen der metallischen Wände mit einer Metallätzlösung gebildet werden können.

Die Dicke der funktionalen Schicht **3** beträgt je nach Anwendungsfall vorzugsweise 10 nm bis 100 µm. Sollen katalytische Schichten gebildet werden, sind für den gewünschten Zweck auch äußerst dünne Schichten ausreichend.

Die funktionale Schicht **3** wird vorzugsweise nur auf den freiliegenden Kupferoberflächen gebildet. Dies kann insbesondere durch den Einsatz eines elektrolytischen Metallabscheideverfahrens gewährleistet werden. Falls sich die funktionale Schicht auch auf die Abdeckschicht oder die perforierte Folie **2** erstreckt, wird diese anschließend zusammen mit der Abdeckschicht oder der perforierten Folie von der Oberfläche der Metallfolie **1** wieder entfernt. Dadurch wird immer gewährleistet, daß in den zu den Strömungskanälen benachbarten Bereichen auf der Oberfläche der Metallfolie in erfindungsgemäßer Weise keine funktionale Schicht gebildet wird.

Gemäß Verfahrensschritt **c'** wird die photoempfindliche Schicht, die Siebdrucklackschicht, die perforierte Folie oder der Metallresist anschließend wieder entfernt, beispielsweise aufgelöst. Wird eine photoempfindliche Schicht, eine Siebdrucklackschicht oder eine perforierte Folie beim Strukturierungsverfahren angewendet, so können diese mittels organischer oder mit Wasser gemischter organischer Lösungsmittel oder mit einer wäßrig-alkalischen Lösung wieder entfernt werden. Das Lösungsmittel enthält vorzugsweise ein Netzmittel mit einer niedrigen Oberflächenspannnung. Die Wahl des Lösungsmittels richtet sich nach der Art des aufzulösenden Kunststoffmaterials (Siebdrucklack, photoempfindliche Schicht, perforierte Folie). Für Polymethylmethacrylat als Kunststoffmaterial sind beispielsweise Aceton, Chloroform, Butanon, 1,4-Dioxan und N,N-Dimethylformamid und deren Gemische und für Photoresiste N-Methylpyrrolidon, Trichlorethan, Dimethylsulfoxid und Methytenchlorid und deren Gemische geeignet. Außerdem können wäßrige alkalische Systeme mit geeigneten Cosolventien eingesetzt werden. Wird eine Metallresistschicht zum selektiven Ätzen der Strömungskanäle eingesetzt, so wird je nach Art des Metallresists eine geeignete Säure, meist anorganische Säure, oder ein Säuregemisch verwendet.

Die in dieser Weise hergestellte Einzellage für ein Mikrobauteil, beispielsweise einen Mikroreaktor, Wärmeaustauscher, Mischer oder Verdampfer, ist als freitragende Kupferfolie 1 ausgebildet, die die vorgeformten Strömungskanäle als Vertiefungen enthält und in der ausschließlich die Strömungskanalwände zumindest teilweise mit einer geeigneten funktionalen Schicht **3** überzogen sind.

Mehrere dieser Einzellagen können anschließend miteinander verbunden werden, beispielsweise mit einem Diffusionsbondverfahren. Hierzu werden die Einzellagen passergenau übereinander gestapelt und dann durch Einstellen einer ausreichend hohen Temperatur miteinander verschweißt. Es können grundsätzlich auch andere Fügeverfahren eingesetzt werden, beispielsweise ein Lötverfahren oder ein Klebeverfahren. Die nicht von einer darüber liegenden Einzellage abgeschlossenen Strömungskanäle der obersten Einzellage werden von einem Abschlußsegment verschlossen. Hierzu kann beispielsweise eine weitere Metallfolie, die keine Strömungskanäle enthält, zusammen mit dem Einzellagenstapel verschweißt werden. Gleichermaßen kann auch ein Mikrobauteil hergestellt werden, bei dem lediglich eine Einzellage mit einem Abschlußsegment verbunden wird.

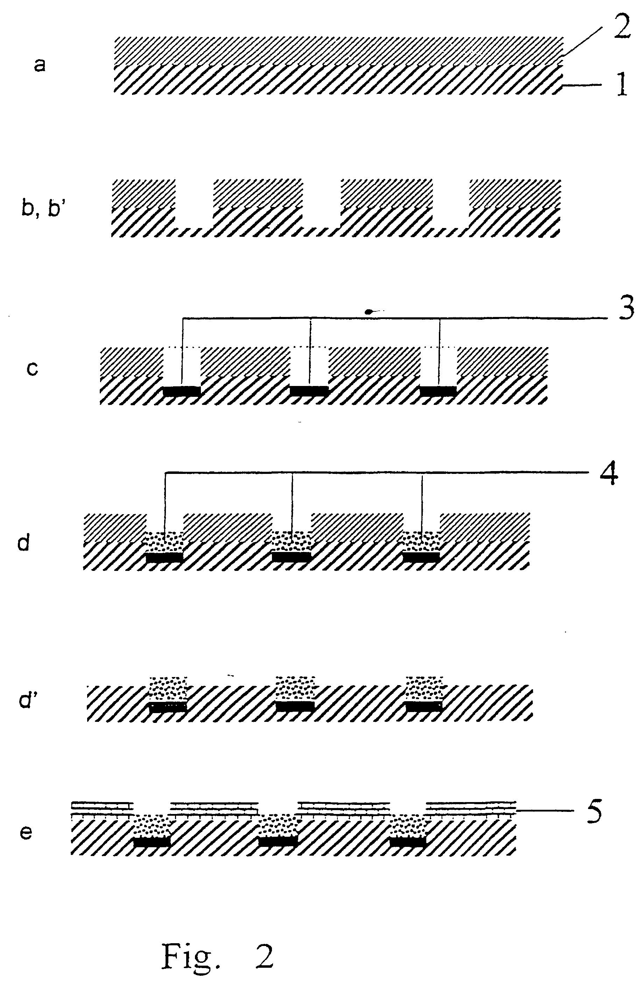

### In Figur 2 ist eine weitere Verfahrensvariante B dargestellt:

Die Verfahrensschritte **a, b, b'** und **c** sind in diesem Fall identisch mit den entsprechenden Schritten im vorhergehenden Ablauf. Um eine weitere Metallschicht, beispielsweise eine Lotschicht (beispielsweise aus Zinn/Blei- oder Zinn/Wismut-Legierung), ausschließlich auf die Stellen auf der Metallfolie **1** (oder der ersten Metallschicht) aufzubringen, die nicht den Strömungskanalbereichen entsprechen, wird im Anschluß an die Bildung der funktionalen Schicht **3** ein weiterer Schutzfilm **4** ausschließlich auf der funktionalen Schicht in den Strömungskanälen gebildet (Verfahrensschritt **d**). Bei der Auswahl des Materials dieses Schutzfilmes muß darauf geachtet werden, daß die Abdeckschicht **2** (Photoresist-, Siebdrucklackschicht, perforierte Folie oder Metallresistschicht) und dieser Schutzfilm nur in unterschiedlichen Lösungsmitteln entfernbar sind. Beispielsweise könnte die Abdeckschicht aus einem alkalilöslichen Photoresist bestehen, der mit einer wäßrig-alkalischen Lösung entfernbar ist, und der Schutzfilm aus einem Elektrophoreselack (gebildet beispielsweise mit einer anaphoretischen oder kataphoretischen Tauchlackierung), der ausschließlich in einem organischen Lösungsmittel entfernt werden kann.

Da der Schutzfilm **4** ausschließlich auf die funktionale Schicht **3** aufgebracht werden soll, bietet sich als selektiv abscheidendes Verfahren für den Schutzfilm ein Elektrophoreseverfahren an, mit dem Lacke ausschließlich auf elektrisch leitfähige Unterlagen abgeschieden werden können, wenn die funktionale Schicht nicht elektrisch isolierend wirkt und wenn gleichzeitig die Abdeckschicht **2** elektrisch isolierend ist.

Danach wird die Abdeckschicht, die perforierte Folie oder die Metallresistschicht **2** wieder entfernt (Verfahrensschritt **d'**). Es bleiben die in den Strömungskanälen enthaltenen Schutzfilmbereiche **4** zurück.

In den freiliegenden Bereichen der Metallfolie **1** kann danach gemäß Verfahrensschritt **e** die weitere Metallschicht **5**, beispielsweise eine Lotschicht, abgeschieden werden. Es können wiederum dieselben Verfahrensalternativen wie für die Bildung der funktionalen Schicht eingesetzt werden, d.h. ein galvanotechnisches Verfahren oder auch ein PVD-, CVD-, PECVD-, Sputter- oder Aufdampf-Verfahren. Ein elektrolytisches Metallabscheideverfahren ist besonders günstig, da die weitere Metallschicht in diesem Falle selektiv ausschließlich auf der Metallfolie **1** abgeschieden werden kann, nicht jedoch auf dem Schutzfilm **4** gebildet wird.

Danach wird der Schutzfilm **4** aus den Strömungskanalbereichen wieder entfernt (Verfahrensschritt **f**). Hierzu wird ein geeignetes Lösungsmittel eingesetzt.

Anschließend können mehrere dieser Einzellagen miteinander verbunden werden und zusätzlich die oberste Einzellage mit einem Abschlußsegment versehen werden, um den Mikroreaktor herzustellen. Beim Stapeln der Einzellagen werden die Bereiche, in denen das weitere Metall abgeschieden ist, mit der Rückseite der jeweils angrenzenden Einzellage in Kontakt gebracht. Wird ein niedrig schmelzendes Material für das weitere Metall ausgewählt, so kann dieses zur sicheren Verbindung der Einzellagen untereinander als Lotschicht **5** dienen.

In einer weiteren Variante dieser Ausführungsform besteht auch die Möglichkeit, den Schutzfilm **4** auch erst nach dem Stapeln und Zusammenfügen der Einzellagen und des Abschlußsegments wieder zu entfernen. Da der Schutzfilm den Kanalquerschnitt nicht vollständig ausfüllt, ist eine Entfernung nach dem Zusammenfügen des Bauteils nicht schwierig. Hierzu kann das zusammengefügte Mikrobauteil beispielsweise mit einem Lösungsmittel für den Schutzfilm unter gleichzeitiger Einwirkung von Ultraschall und Wärme in Kontakt gebracht werden. Alternativ kann der Schutzfilm auch durch Pyrolyse entfernt werden. In diesem Fall wird die gebildete Mikrobauteilstruktur in einen Ofen überführt und der Schutzfilm thermisch zersetzt. Eventuelle Reste des zersetzten organischen Materials können anschließend in einem Lösungsmittel entfernt werden, wiederum vorzugsweise unter Einwirkung von Ultraschall und in Gegenwart eines geeigneten Netzmittels. In einer weiteren Alternative kann der Kunststoff des Schutzfilmes auch mit einem Plasmaverfahren entfernt werden. Hierzu wird die fertiggestellte Mikrobauteilstruktur in eine Glimmentladungszone eines Plasmareaktors gebracht. In einer noch weiteren Alternative kann der Schutzfilm mit überkritischen Flüssigkeiten entfernt werden. Hierzu wird die Mikrobauteilstruktur unter geeigneten Druck- und Temperaturverhältnissen, beispielsweise in einem Autoklaven, mit Kohlendioxid, Ethylen, Propan, Ammoniak, Distickstoffdioxid, Wasser, Toluol, Stickstoffheterocyclen oder anderen Stoffen, die sich in überkritischem Zustand befinden, in Kontakt gebracht. Gut geeignet sind solche überkritischen Flüssigkeiten, die bereits nahe Raumtemperatur in den überkritischen Zustand überführbar sind. Eine gut geeignete überkritische Flüssigkeit ist Kohlendioxid. Diese Verfahrensweise ist allerdings nur dann einsetzbar, wenn der Schutzfilm den Bedingungen beim Zusammenfügen der Einzellagen standhält. Andererseits bietet diese Vorgehensweise den Vorteil, daß die Lotschicht **5** die funktionale Schicht **3** unter diesen Bedingungen nicht schädigen kann, da diese während des Fügeprozesses von dem Schutzfilm geschützt ist.

Die Verfahrenvariante gemäß **Figur 2** bietet den Vorteil, daß die funktionale Schicht 3 und eine Fügeschicht (Lotschicht) **5** miteinander kombiniert werden können, ohne sich wechselseitig zu stören.

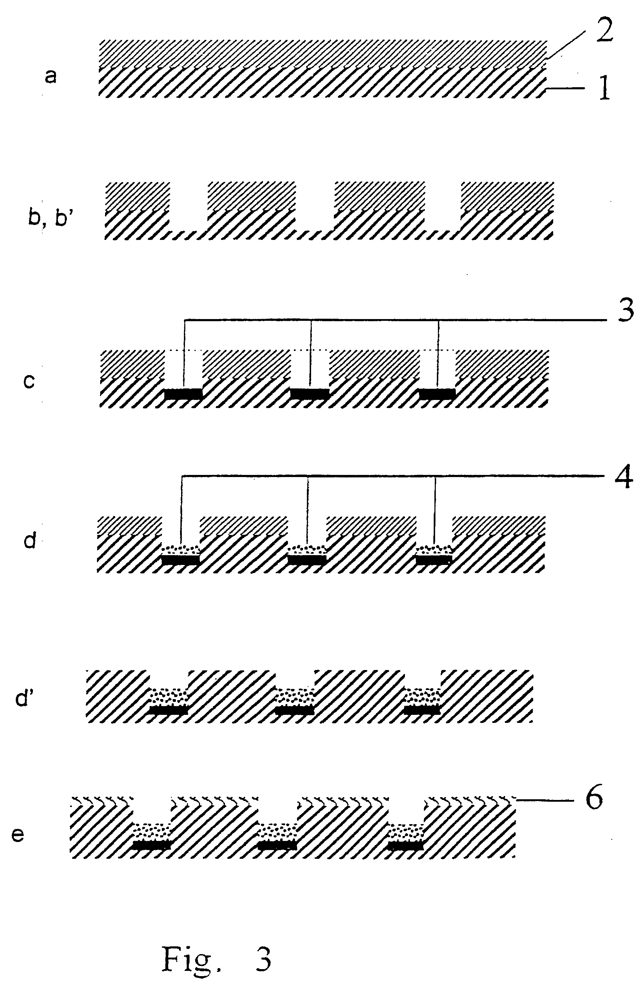

In **Figur 3** ist der Verfahrensablauf für eine weitere Verfahrensvariante C dargestellt. Der Verfahrensablauf unterscheidet sich von dem zuvor beschriebenen Ablauf gemäß **Figur 2** lediglich dadurch, daß anstelle der weiteren Metallschicht **5** eine Kleberschicht **6** auf die erste Metallschicht oder Metallfolie **1** aufgebracht wird. Für die Kleberschicht kann ein übliches Material eingesetzt werden, beispielsweise ein Zweikomponenten-Kleber.

Auch in diesem Falle kann der Schutzfilm **4** alternativ auch nach dem Zusammenfügen der Einzellagen und des Abschlußsegments entfernt werden. In diesem Fall werden gleichzeitig mit der Schutzschicht auch eventuell in die Strömungskanäle gelangte Kleberreste **6** mit entfernt.

Diese Verfahrensalternative wird dann eingesetzt, wenn thermisch äußerst empfindliche funktionale Schichten **3** auf die Wände der Strömungskanäle aufgebracht sind. Vorteilhaft ist auch, daß die gebildeten Mikrobauteile eine gute Dichtigkeit gegen austretendes Fluid aufweisen.

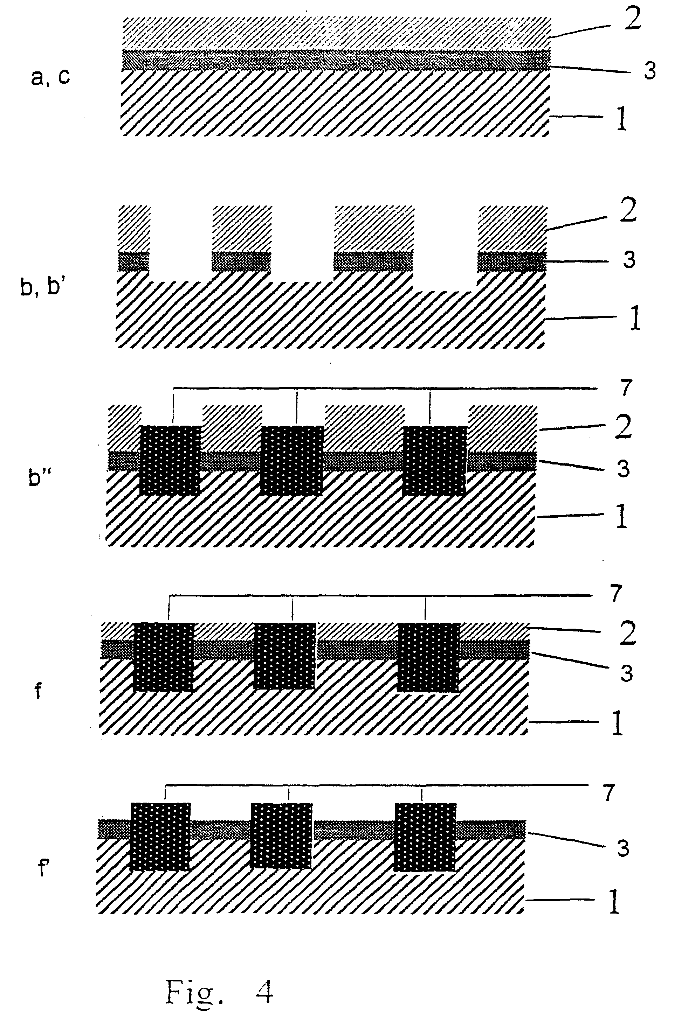

In **Figur 4** ist eine weitere Verfahrensvariante D dargestellt. In diesem Fall wird auf die erste Kupferschicht oder Kupferfolie **1** zuerst eine funktionale Schicht **3** ganzflächig aufgebracht. Für die Art des Materials für die funktionale Schicht, deren Dicke und das hierfür angewendete Auftragsverfahren bestehen dieselben Möglichkeiten und Randbedingungen wie bei den zuvor beschriebenen Varianten A, B und C (Verfahrensschritt **a** (Herstellen der ersten Metallschicht oder Metallfolie) und Verfahrensschritt **c** (Bilden der funktionalen Schicht)).

Anschließend wird eine relativ dicke Abdeckschicht, beispielsweise ein Positivphotoresisifilm **2** (oder eine Siebdrucklack-, Metallresistschicht oder perforierte Folie) auf die funktionale Schicht **3** aufgebracht. Die Dicke dieser Abdeckschicht muß so groß sein, daß in Vertiefungen in dieser Schicht gebildete Metallstege für die Wände der Strömungskanäle gebildet werden können, ohne daß diese die Abdeckschicht überwachsen können. Beispielsweise kann die Photoresistschicht 30 µm dick sein. Danach wird die Positivphotoresistschicht mit dem Muster der Strömungskanäle belichtet, wobei die Partien belichtet werden, die den Strömungskanälen nicht entsprechen. Beim anschließenden Entwickeln der belichteten Photoresistschicht werden die Bereiche der Photoresistschicht entfernt, die belichtet worden sind und den zu bildenden Strömungskanälen entsprechen (Verfahrensschritt **b**).

Danach wird mindestens ein Teil der funktionalen Schicht **3** an den freigelegten Stellen sowie gegebenenfalls auch ein Teil der darunterliegenden Metallschicht bzw. -folie **1** mit einem Ätzmittel entfernt, so daß sich ein relativ tiefer Graben in der Abdeckschicht, der funktionalen Schicht und gegebenenfalls der Metallschicht bzw. -folie bildet (Verfahrensschritt **b'**).

In Verfahrensschritt **b"** wird danach eine weitere Metallschicht **7** in den entstandenen Vertiefungen mit einem galvanotechnischen Metallisierungsverfahren elektrolytisch oder stromlos abgeschieden. Die dabei gebildeten Stege dienen zur Herstellung der Wände der Strömungskanäle. Hierzu kann dasselbe Metall abgeschieden werden, aus dem die erste Metallschicht oder Metallfolie **1** besteht, beispielsweise Kupfer.

Anschließend kann die Oberfläche planarisiert werden, indem die überstehende Photoresistschicht **2** beispielsweise durch Schleifen oder Polieren teilweise bis zum Niveau der Stege **7** entfernt wird (Verfahrensschritt **f**).

Im sich daran anschließenden Verfahrensschritt **f**' wird die Photoresistschicht **2** entfernt, indem eine der zuvor beschriebenen Verfahrensweisen angewendet wird. Die sich nach Abschluß dieser Verfahrensfolge ergebende Einzellage enthält Strömungskanäle, die im Bodenbereich die funktionale Schicht **3** enthalten. Die seitlichen Wände der Strömungskanäle werden durch die Stege **7** gebildet.

Zum Abschluß werden mehrere Einzellagen und ein Abschlußsegment gestapelt und miteinander zusammengefügt, wobei auch in diesem Falle die zuvor beschriebenen Verfahren eingesetzt werden.

Auch in diesem Falle besteht die Möglichkeit, die Photoresistschicht **2** erst nach dem Stapeln und Zusammenfügen der Einzellagen und des Abschlußsegments zu entfernen.

Diese Variante bietet den Vorteil, daß die Stege **7** aus einem Metall bestehen können, das entweder selbst einen niedrigeren Schmelzpunkt als die erste Metallschicht oder -folie **1** aufweist oder das mit der funktionalen Schicht **3** eine niedrig schmelzende intermetallische Phase bildet, beispielsweise ein Eutektikum. Dadurch können die Einzellagen und das Abschlußsegment wiederum bei einer entsprechend niedrigeren Temperatur miteinander verbunden werden, so daß die funktionale Schicht nicht in das Material der Kanalwände eindiffundieren kann.

## Patentansprüche

1. Verfahren zum Herstellen von Mikrobauteilen mit mindestens einer Einzellage, die von Wänden begrenzte innere Strukturen in den Bauteilen und funktionale Schichten auf den Wänden der Strukturen aufweist, mit folgenden Verfahrensschritten:
**A.** Herstellen der mindestens einen Einzellage durch
**a.** Herstellen einer ersten Metallschicht oder einer Metallfolie;
**b.** Bilden der inneren Strukturen in und/oder auf der ersten Metallschicht oder Metallfolie durch geeignete Ätzverfahren und/oder Metallauftragsverfahren; und
**B.** Stapeln und Zusammenfügen der einen Einzellage mit einem die inneren Strukturen abschließenden Segment oder mehrerer Einzellagen miteinander und mit dem abschließenden Segment,
**gekennzeichnet durch** den weiteren Verfahrensschritt
**c.** Bilden der funktionalen Schichten vor Durchführung des Verfahrensschrittes **B** ausschließlich auf den Wänden der inneren Strukturen.

2. Verfahren nach Anspruch 1, **dadurch gekennzeichnet, daß** die inneren Strukturen in und/oder auf der ersten Metallschicht oder Metallfolie durch folgende Verfahrensschritte gebildet werden:
**b.** Abbilden der inneren Strukturen auf der ersten Metallschicht oder Metallfolie durch ein Strukturierungsverfahren; und
**b**'. selektives Ätzen der beim Strukturieren freigelegten Bereiche der ersten Metallschicht oder Metallfolie.

3. Verfahren nach Anspruch 2, **dadurch gekennzeichnet, daß** das Strukturierungsverfahren gemäß Verfahrensschritt A.b folgende Verfahrensalternativen umfaßt:
**b1.** Überziehen mindestens einer Oberfläche der ersten Metallschicht oder Metallfolie mit einer photoempfindlichen Schicht, Belichten der photoempfindlichen Schicht mit dem Muster der Strukturen und Freilegen der ersten Metallschicht oder Metallfolie an allen Stellen, die den zu bildenden Strukturen entsprechen oder
**b2.** Überziehen mindestens einer Oberfläche der ersten Metallschicht oder Metallfolie mit einer Siebdrucklackschicht an den Stellen auf der Oberfläche, die den zu bildenden Strukturen nicht entsprechen; oder
**b3.** Laminieren einer perforierten Folie auf mindestens eine Oberfläche der ersten Metallschicht oder Metallfolie, wobei die Perforationen an allen Stellen der Oberfläche vorgesehen sind, die den zu bildenden Strukturen entsprechen.

4. Verfahren nach Anspruch 3, **dadurch gekennzeichnet, daß** die photoempfindliche Schicht, die Siebdrucklackschicht oder die perforierte Folie zwischen den Verfahrensschritten **c** und **B** oder nach Verfahrensschritt **B** wieder entfernt wird.

5. Verfahren nach einem der Ansprüche 3 und 4, **dadurch gekennzeichnet, daß** weitere Metallschichten vor Durchführung von Verfahrensschritt B ausschließlich auf die nicht mit den funktionalen Schichten überzogenen Oberflächenbereiche der ersten Metallschicht oder Metallfolie aufgebracht werden durch:
**d.** Abdecken ausschließlich der funktionalen Schichten durch einen Schutzfilm;
**e.** Bilden weiterer Metallschichten nach dem Entfernen der photoempfindlichen Schicht, der Siebdrucklackschicht oder der perforierten Folie auf den freiliegenden Oberflächenbereichen der ersten Metallschicht oder Metallfolie; und
**f.** Entfernen des Schutzfilmes.

6. Verfahren nach einem der Ansprüche 3 und 4, **dadurch gekennzeichnet, daß** Kleberschichten vor Durchführung von Verfahrensschritt **B** ausschließlich auf die nicht mit den funktionalen Schichten überzogenen Oberflächenbereiche der ersten Metallschicht oder Metallfolie aufgebracht werden durch:
**d.** Abdecken ausschließlich der funktionalen Schichten durch einen Schutzfilm;
**e.** Bilden der Kleberschichten nach dem Entfernen der photoempfindlichen Schicht, der Siebdrucklackschicht oder der perforierten Folie auf den freiliegenden Oberflächenbereichen der ersten Metallschicht oder Metallfolie; und
**f.** Entfernen des Schutzfilmes.

7. Verfahren nach Anspruch 1, **dadurch gekennzeichnet, daß** die inneren Strukturen in der ersten Metallschicht oder Metallfolie durch folgende Verfahrensschritte gebildet werden:
**c.** Bilden einer funktionalen Schicht auf der ersten Metallschicht oder Metallfolie;
**b.** Abbilden der inneren Strukturen durch eine der folgenden Verfahrensalternativen:
**b1.** Überziehen mindestens einer Oberfläche der funktionalen Schicht mit einer photoempfindlichen Schicht, Belichten der photoempfindlichen Schicht mit dem Muster der Strukturen und Freilegen der ersten Metallschicht oder Metallfolie an allen Stellen, die den zu bildenden Strukturen nicht entsprechen; oder
**b2.** Überziehen mindestens einer Oberfläche der funktionalen Schicht mit einer Siebdrucklackschicht an den Stellen auf der Oberfläche, die den zu bildenden Strukturen entsprechen; oder
**b3.** Laminieren einer perforierten Folie auf mindestens eine Oberfläche der funktionalen Schicht, wobei die Perforationen an allen Stellen der Oberfläche vorgesehen sind, die den zu bildenden Strukturen nicht entsprechen; und
**b'.** Bilden von Vertiefungen in der funktionalen Schicht durch selektives Ätzen der freiliegenden Bereiche der funktionalen Schicht;
**b".** Bilden von Metall ausschließlich in den in Verfahrensschritt **b'** gebildeten Vertiefungen.

8. Verfahren nach Anspruch 7, **dadurch gekennzeichnet, daß** durch Schleifen und/oder Polieren eine durch die Metallstege und die photoempfindliche Schicht, die Siebdrucklackschicht oder die perforierte Folie gebildete im wesentlichen ebene Oberfläche hergestellt wird.

9. Verfahren nach einem der Ansprüche 7 und 8, **dadurch gekennzeichnet, daß** die photoempfindliche Schicht, die Siebdrucklackschicht oder die perforierte Folie vor Durchführung des Verfahrensschrittes **B** wieder entfernt wird.

10. Verfahren nach einem der vorstehenden Ansprüche, **dadurch gekennzeichnet, daß** die Einzellage mit dem abschließenden Segment oder mehrere Einzellagen miteinander und mit dem abschließenden Segment durch ein Löt-, Schweiß- oder Klebeverfahren verbunden werden.

11. Verfahren nach einem der vorstehenden Ansprüche, **dadurch gekennzeichnet, daß** die erste Metallschicht oder Metallfolie aus Kupfer, Stahl oder Aluminium gebildet wird.

12. Verfahren nach einem der vorstehenden Ansprüche, **dadurch gekennzeichnet, daß** die funktionalen Schichten aus Metallen oder Legierungen von Metallen der VIII. Nebengruppe des Periodensystems der Elemente gebildet werden, vorzugsweise aus einem Metall, ausgewählt aus der Gruppe, bestehend aus Platin, Iridium, Palladium und Gold.

## Claims

1. Method of producing microcomponents with at least one individual layer which has intemal structures, defined by walls, in the components and operational layers on the walls of the structures, said method having the following method steps:
**A.** producing the at least one individual layer by
**a.** producing a first metal layer or a metal foil;
**b.** forming the internal structures in and/or on the first metal layer or metal foil by suitable etching methods and/or metal plating methods; and
**B.** stacking and joining together the one individual layer with a segment, which terminates the internal structures, or a plurality of individual layers with one another and with the terminating segment,
**characterised by** the additional method step:
**c**. forming the operational layers, prior to method step **B** being accomplished, exclusively on the walls of the internal structures,

2. Method according to claim 1, **characterised in that** the internal structures are formed in and/or on the first metal layer or metal foil by the following method steps:
**b.** reproducing the internal structures onto the first metal layer or metal foil by a structuring method; and
**b'.** selectively etching the regions of the first metal layer or metal foil which are exposed during the structuring process.

3. Method according to claim 2, **characterised in that** the structuring method according to method step A.b includes the following method alternatives:
**b1.** coating at least one surface of the first metal layer or metal foil with a photosensitive layer, illuminating the photosensitive layer with the pattern of the structures and exposing the first metal layer or metal foil at all of the locations which correspond to the structures to be formed, or
**b2.** coating at least one surface of the first metal layer or metal foil with a layer of screen printing lacquer at the locations on the surface which do not correspond to the structures to be formed; or
**b3.** laminating a perforated foil onto at least one surface of the first metal layer or metal foil, the perforations being provided at all of the locations of the surface which correspond to the structures to be formed.

4. Method according to claim 3, **characterised in that** the photosensitive layer, the layer of screen printing lacquer or the perforated foil is removed again between the method steps **c** and **B** or after method step **B**.

5. Method according to one of claims 3 and 4, **characterised in that**, prior to method step B being accomplished, additional metal layers are exclusively applied to the surface regions of the first metal layer or metal foil which are not coated with the operational layers by:
**d.** covering exclusively the operational layers by a protective film;
**e.** forming additional metal layers, after the removal of the photosensitive layer, the layer of screen printing lacquer or the perforated foil, on the exposed surface regions of the first metal layer or metal foil; and
**f.** removing the protective film.

6. Method according to one of claims 3 and 4, **characterised in that**, prior to method step **B** being accomplished, layers of adhesive are exclusively applied to the surface regions of the first metal layer or metal foil which are not coated with the operational layers by:
**d.** covering exclusively the operational layers by a protective film;
**e.** forming the layers of adhesive, after the removal of the photosensitive layer, the layer of screen printing lacquer or the perforated foil, on the exposed surface regions of the first metal layer or metal foil; and
**f.** removing the protective film.

7. Method according to claim 1, **characterised in that** the internal structures in the first metal layer or metal foil are formed by the following method steps:
**c.** forming an operational layer on the first metal layer or metal foil;
**b.** reproducing the intemal structures by one of the following method alternatives;
**b1.** coating at least one surface of the operational layer with a photosensitive layer, illuminating the photosensitive layer with the pattern of the structures and exposing the first metal layer or metal foil at all of the locations which do not correspond to the structures to be formed; or
**b2.** coating at least one surface of the operational layer with a layer of screen printing lacquer at the locations on the surface which correspond to the structures to be formed; or
**b3.** laminating a perforated foil onto at least one surface of the operational layer, the perforations being provided at all of the locations of the surface which do not correspond to the structures to be formed; and
**b'.** forming indentations in the operational layer by selectively etching the exposed regions of the operational layer; and
**b".** forming metal exclusively in the indentations formed in method step **b'.**

8. Method according to claim 7, **characterised in that** a substantially flat surface is produced by grinding and/or polishing, said surface being formed by the metal webs and the photosensitive layer, the layer of screen printing lacquer or the perforated foil.

9. Method according to one of claims 7 and 8, **characterised in that** the photosensitive layer, the layer of screen printing lacquer or the perforated foil is removed again prior to the method step **B** being accomplished.

10. Method according to one of the preceding claims, **characterised in that** the individual layer is joined to the terminating segment, or a plurality of Individual layers are joined together and to the terminating segment, by a soldering, welding or adhering method.

11. Method according to one of the preceding claims, **characterised in that** the first metal layer or metal foil is formed from copper, steel or aluminium.

12. Method according to one of the preceding claims, **characterised in that** the operational layers are formed from metals or alloys of metals of the Vlllth secondary group of the periodic table of elements, preferably from a metal selected from the group consisting of platinum, iridium, palladium and gold.

## Revendications

1. Procédé de production de micro-éléments avec au moins une couche isolée qui présente des structures internes limitées par des parois dans les éléments et des couches fonctionnelles sur les parois des structures, comprenant les étapes de procédé suivantes :
A. Réalisation de ladite au moins une couche isolée par
a. Réalisation d'une première couche métallique ou d'un film métallique ;
b. Formation des structures internes dans et/ou sur la première couche métallique ou le film métallique par des procédés de gravure et/ou des procédés de dépôt de métal appropriés ; et
B. Empilage et assemblage de ladite une couche isolée avec un segment fermant les structures internes ou de plusieurs couches isolées les unes avec les autres et avec le segment de fermeture,
**caractérisé par** l'étape de procédé supplémentaire
c. Formation des couches fonctionnelles uniquement sur les parois des structures internes, avant l'exécution de l'étape de procédé B.

2. Procédé selon la revendication 1, **caractérisé en ce que** les structures internes sont formées dans et/ou sur la première couche métallique ou le film métallique par les étapes de procédé suivantes:
b. Report des structures internes sur la première couche métallique ou le film métallique par un procédé de structuration ; et
b'. Gravure sélective des zones de la première couche métallique ou du film métallique mises à nu lors de la structuration.

3. Procédé selon la revendication 2, **caractérisé en ce que** le procédé de structuration de l'étape de procédé A.b comprend les variantes de procédé suivantes :
b1. Revêtement d'au moins une surface de la première couche métallique ou du film métallique avec une couche photosensible, insolation de la couche photosensible avec le motif des structures et mise à nu de la première couche métallique ou du film métallique à tous les endroits correspondant aux structures à former ; ou
b2. Revêtement d'au moins une surface de la première couche métallique ou du film métallique avec une couche de laque sérigraphiée aux endroits de la surface qui ne correspondent pas aux structures à former ; ou
b3. Stratification d'un film perforé sur au moins une surface de la première couche métallique ou du film métallique, les perforations étant prévues à tous les endroits de la surface qui correspondent aux structures à former.

4. Procédé selon la revendication 3, **caractérisé en ce que** la couche photosensible, la couche de laque sérigraphiée ou le film perforé sont à nouveau enlevés entre les étapes de procédé c et B ou après l'étape de procédé B.

5. Procédé selon la revendication 3 ou la revendication 4, **caractérisé en ce que**, avant l'exécution de l'étape de procédé B, d'autres couches métalliques sont déposées exclusivement sur les zones de la surface de la première couche métallique ou du film métallique qui ne sont pas revêtues avec les couches fonctionnelles, par :
d. Masquage uniquement des couches fonctionnelles au moyen d'un film de protection ;
e. Formation d'autres couches métalliques, après enlèvement de la couche photosensible, de la couche de laque sérigraphiée ou du film perforé, sur les zones mises à nu de la surface de la première couche métallique ou du film métallique ; et
f. Enlèvement du film de protection.

6. Procédé selon la revendication 3 ou la revendication 4, **caractérisé en ce que**, avant l'exécution de l'étape de procédé B, des couches d'adhésif sont déposées uniquement sur les zones de la première couche métallique ou du film métallique qui ne sont pas revêtues avec les couches fonctionnelles, par:
d. Masquage uniquement des couches fonctionnelles au moyen d'un film de protection ;
e. Formation des couches d'adhésif, après enlèvement de la couche photosensible, de la couche de laque sérigraphiée ou du film perforé, sur les zones mises à nu de la surface de la première couche métallique ou du film métallique ; et
f. Enlèvement du film de protection.

7. Procédé selon la revendication 1, **caractérisé en ce que** les structures internes dans la première couche métallique ou le film métallique sont formées par les étapes de procédé suivantes :
c. Formation d'une couche fonctionnelle sur la première couche métallique ou le film métallique ;
b. Report des structures internes par l'une des variantes de procédé suivantes :
b1. Revêtement d'au moins une surface de la couche fonctionnelle avec une couche photosensible, insolation de la couche photosensible avec le motif des structures et mise à nu de la première couche métallique ou du film métallique à tous les endroits qui ne correspondent pas aux structures à former ; ou
b2. Revêtement d'au moins une surface de la couche fonctionnelle avec une couche de laque sérigraphiée aux endroits de la surface qui correspondent aux structures à former ; ou
b3. Stratification d'un film perforé sur au moins une surface de la couche fonctionnelle, les perforations étant prévues à tous les endroits de la surface qui ne correspondent pas aux structures à former ; et
b'. Formation de creux dans la couche fonctionnelle par gravure sélective des zones mises à nu de la couche fonctionnelle ;
b". Formation de métal uniquement dans les creux formés dans l'étape de procédé b'.

8. Procédé selon la revendication 7, **caractérisé en ce qu'**une surface formée par les nervures métalliques et la couche photosensible, la couche de laque sérigraphiée ou le film perforé et pratiquement plane est réalisée par meulage et/ou polissage.

9. Procédé selon la revendication 7 ou la revendication 8, **caractérisé en ce que** la couche photosensible, la couche de laque sérigraphiée ou le film perforé sont à nouveau enlevés avant l'exécution de l'étape de procédé B.

10. Procédé selon l'une des revendications précédentes, **caractérisé en ce que** la couche isolée est reliée au segment de fermeture ou plusieurs couches isolées sont reliées les unes aux autres et au segment de fermeture par un procédé de brasage, de soudage ou de collage.

11. Procédé selon l'une des revendications précédentes, **caractérisé en ce que** la première couche métallique ou le film métallique est réalisé(e) en cuivre, en acier ou en aluminium.

12. Procédé selon l'une des revendications précédentes, **caractérisé en ce que** les couches fonctionnelles sont réalisées en métaux ou en alliages de métaux du sous-groupe VXII de la classification périodique des éléments, de préférence en un métal choisi dans le groupe constitué par le platzne, l'iridium, le palladium et l'or.
